# EUROPEAN PATENT SPECIFICATION

(11) **EP 2 771 306 B1**
(45) Date of publication and mention of the grant of the patent: **24.02.2016**
(21) Application number: 12790399.5
(22) Date of filing: 26.10.2012
(51) Int. Cl.: C04B 41/63, H01L 31/048

(54) **PREPARATION OF CEMENTITIOUS ARTICLES WITH A HIGH SURFACE FINISH FOR USE IN ELECTRICAL DEVICES**
HERSTELLUNG VON ZEMENTGEGENSTÄNDEN MIT HOHER OBERFLÄCHENGÜTE ZUR VERWENDUNG BEI ELEKTRISCHEN VORRICHTUNGEN
PRÉPARATION D'ARTICLES CIMENTAIRES AYANT UNE FINITION DE SURFACE ÉLEVÉE POUR UTILISATION DANS DES DISPOSITIFS ÉLECTRIQUES

(30) Priority: 27.10.2011 IT MI20111950
(43) Date of publication of application: 03.09.2014
(73) Proprietor: ITALCEMENTI S.p.A., 24121 Bergamo (IT)
(72) Inventor: ALFANI, Roberta, I-24128 Bergamo (IT); CAPONE, Claudia, I-20060 Cassina Dé Pecchi (Milano) (IT); ROMBOLA' OTTAVIO, Antonio, I-88068 Soverato (Catanzaro) (IT)
(74) Representative: Gerli, Paolo
(86) International application number: PCT/EP2012/004506
(87) International publication number: WO 2013/060477

(56) References cited:
- WO-A1-2011/132143
- DE-A1- 1 954 013

## Description

### Field of the invention

The present invention relates in general to the field of cementitious articles and their use in the energy sector. Described herein are: a process for coating prefabricated cement articles, the articles obtained with said process, and their use in the construction sector, for non-structural applications, preferably as cladding and covering elements, both of the horizontal type and of the vertical type, with the aim of generating and/or transporting energy; said coated articles, having a small thickness and very low surface roughness, are in fact useful as substrates for deposition of metallic films and other thin films, during the construction of electrical devices such as solar cells, for example. The resultant products are of particular interest for applications in the field of Building Integrated Photovoltaics (BIPV), for aesthetic purposes and optimum integration of the photovoltaic modules in an urban context.

### Prior art

Photovoltaic devices are being increasingly used in an urban context, as an integrative element in the construction sector, in order to produce useful amounts of alternative energy, thereby reducing the consumption of fossil fuels and the associated polluting emissions.

For this purpose, for some time it has been widespread practice to mount solar panels on the external surfaces of buildings. This solution gives rise to significant problems from an aesthetic point of view, considering the poor imitative capacity of photovoltaic panels and the extensive surface area which must be exposed to solar radiation in order to obtain an appreciable return in energy terms.

The solutions which have been proposed hitherto have been mainly aimed at improving the visual impact of the panel by improving its suitability for integration with the building components, for example by means of the inset arrangement of a panelled area within a roof. In such cases the negative aesthetic impact of the panel is only partially reduced. Moreover, a marked distinction between panel and construction material still remains, which obliges the builder to make specific constructional choices, limiting the freedom of choice as regards possible architectural solutions.

The Applicant has since long been engaged in research into new methods useful for converting materials which are traditionally used in the building sector, into photovoltaic elements or parts thereof. Such an approach would improve the continuity between the constructional components and the photovoltaic elements, while improving the overall aesthetic appearance of the buildings.

Japanese patent JP 6184731 describes a process for coating hard materials such as wood, resins, glass, bricks and tiles with a heat-resistant resin and an additional metallic layer formed by means of sputtering or other methods. Such technology, which has not been designed for the preparation of photovoltaic devices, produces articles coated with a high surface memory, resulting in an irregular surface with raised patterns, which may be increased with ad hoc incisions formed on the coating after application to the substrate; the article is then coated with a metallic film which maintains the underlying pattern. The accentuation of the surface reliefs in the form of given patterns may satisfy a number of aesthetic requirements; however, the resultant products, which are somewhat rough, are not very suitable for electrically conductive applications, in particular photovoltaic applications: the latter envisage coating substrates with very thin metallic films, often in extreme heat and pressure conditions; priority is therefore given to substrates which are as smooth and uniform as possible so as to maximize over time the homogeneity and the stability of adhesion between metal and substrate; a smooth substrate transmits its surface regularity also to the thin superimposed (metallic and absorbent) films, resulting in a smooth external surface which is less prone to the surface accumulation of dust and pollutants which could damage the aesthetic appearance of the surface with time and/or reduce its energy efficiency. These characteristics are at present satisfied by particular materials, for example glass.

### SUMMARY

The present invention relates to a process for the preparation of cementitious articles with a high surface finish, useful for the preparation of electrical, in particular photovoltaic devices, which are highly suitable for integration in the urban building sector. The process envisages the treatment of a prefabricated starting article, at specific temperature and pressure intervals, for a given time period, followed by coating of the article with a film based on a polymer selected from polyimide, polyarylketones or epoxy resins. Heat-resistant cementitious surfaces with an arithmetic mean surface roughness *Ra* which is very low, controlled and regular, without point-like defects, suitable for the deposition of additional thin films, are obtained. This solution is particularly advantageous where, as in most cases, the original cementitious articles do not satisfy the surface roughness requisites of the photovoltaic application. With the invention it is possible to produce cementitious articles such as flat slabs, sunshade elements, ventilated-façade elements, etc., which are obtained from cement-based mortars, cast or formed by means of compression in moulds, said articles being suitable for the deposition of additional thin, metallic and absorbent films, and therefore useful for the manufacture of photovoltaic cells and/or modules. In particular, the polymer coating applied according to the invention maintains unaltered the aforementioned surface properties even after exposure to the temperature and pressure process conditions required for the deposition of thin films of a metallic nature, for example based on molybdenum, and thin absorbent films, for example based on copper, indium (and gallium) diselenides, so-called CI(G)S, for the manufacture of thin-film photovoltaic devices.

### DESCRIPTION OF THE FIGURES

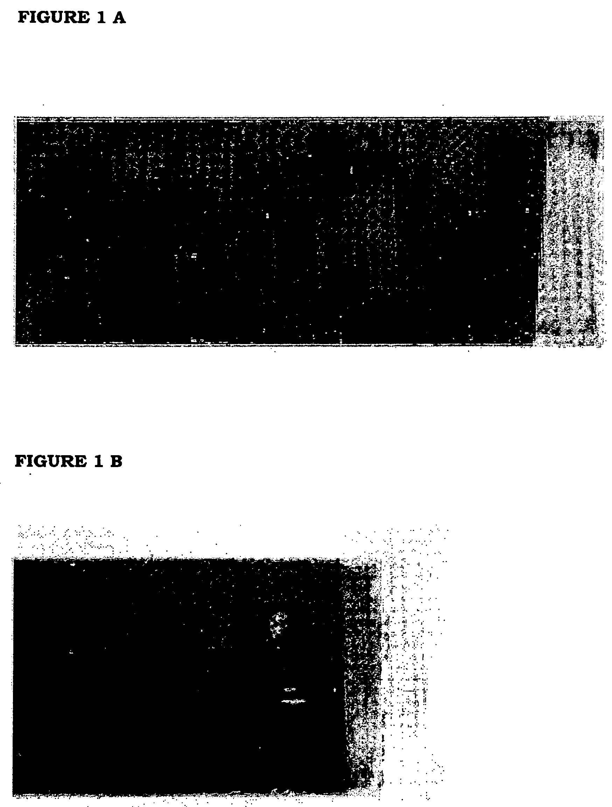

Figure 1a shows the surface of a cementitious article coated with polyimide film and molybdenum metallic film, prepared in accordance with the treatment of the present invention.
Figure 1b shows the surface of a cementitious article coated with polyimide film and molybdenum metallic film, obtained without the treatment according to the present invention.

### DETAILED DESCRIPTION OF THE INVENTION

In the context of the present invention, "low-thickness cementitious articles coated with polymer films having a high surface quality" are understood as meaning prefabricated three-dimensional objects which are to be used in the building sector for non-structural applications, coated with a suitable polymer film, synthesized on a solid material obtained from the hydration of cementitious compositions. "Low thickness" or "small thickness" is understood as meaning a thickness of between 0.1 cm and 5 cm, preferably between 0.2 and 1 cm, more preferably between 0.3 and 0.5 cm.

The form of the cementitious starting article, used in the present invention, may vary greatly depending on the constructional needs; by way of a non-limiting example such forms may include those suitable for the manufacture of flat slabs, sunshade elements ventilated-façade elements, etc.

In the process according to the invention, the cementitious starting article is not coated as such, but undergoes a pre-treatment in selected pressure conditions, of between 13 and 100 kPa (10 and 750 mmHg), preferably between 6.7 and 80 kPa (50 and 600 mmHg), more preferably between 13 and 67 kPa (100 and 500 mmHg), at a temperature of between 80 and 160°C, preferably between 100 and 150°C, more preferably between 110°C and 130°C, for a time period of between of 40 and 120 minutes, preferably between 45 and 90 minutes, more preferably between 50 and 70 minutes.

Subsequently the article is coated with a polymer coating; preferably, this step follows directly the pre-treatment, namely without intermediate storage. The polymer coating may be applied in solution form, using techniques known per se, such as spin coating, atomization, sputtering, etc. A preferred technique is spin coating. The polymer of the coating is preferably polyimide. Alternative polymers which may be used are polyarylketones and epoxy resins.

The surface of the article, which contains the polymer solution layer, is then consolidated and dried by subjecting the article to a heat treatment using known methods depending on the nature of the polymer.

In a preferred method, the coating polymer is obtained directly on the surface of the article, depositing onto it a solution of a suitable precursor, which can be converted into said polymer by means of treatment in situ; in the case of polyimide, the precursor used is polyamide acid (obtained for example by means of copolymerization of suitable monomers such as biphenyltetracarboxylic dianhydride copolymerized with phenylenediamine, or from pyromellitic anhydride copolymerized with oxydianiline); the polyamide acid is converted in situ into polyimide by means of heat treatment, which involves dehydration of the polyamide acid and evaporation of the water formed; this treatment generally requires an initial heating at about 120°C, at a pressure of about 67 kPa (500 mmHg), for about 1 hour, followed by a secondary heating at about 300°C, at ambient pressure, for 1-2 hours.

The thickness of the coating polymer solution applicable to the article is dependent on the roughness of the latter: for example, articles with an arithmetic mean surface roughness *Ra* of about 500 micrometres, coated with a thickness of 300 micrometres (or more) of a 5% by weight polymer coating solution result in the formation of surfaces with the required degree of regularity / uniformity for photovoltaic applications; the amount of coating required for articles with a different *Ra* may be calculated in a directly proportional manner from the aforementioned data.

The arithmetic mean surface roughness (*Ra*) is a standard parameter which can be measured in an automated and reproducible manner by means of profilometers. The *Ra* values referred to here are obtained by means of a 3D Talysurf CCI optical profilometer, of the noncontact type, made by Taylor-Hobson, provided with automatic stage and autofocus. Alternative profilometers provide equivalent results. The system uses green-light scanning interferometry in order to obtain images and measurements of the parts analyzed, providing quantitive information on the structure of surfaces without physically contacting them. The light beam, after passing along the optical path of the microscope, is divided into two inside the interferometric lens. One part is reflected by the sample, while the other part is reflected by a high-quality reference surface present in the lens. The two beams are recombined and the resultant light is directed onto a solid-state telecamera. The interference between the two wave fronts generates an image formed by light and dark bands, called interference fringes, which are indicative of the surface structure of the analyzed part. Since the interference fringes originate only when the analyzed surface is in focus, it is necessary to perform a vertical scanning in order to be able to acquire the interferograms which characterize the height of each pixel forming the matrix of the CCD telecamera. Scanning is performed by means of a piezoelectric transducer situated at the base of the optical head of the microscope. The system is equipped with different types of lenses (50x, 20x, 10x, 5x, 2.5x), to be used in function of the surface characteristics of the sample to be examined. As the lens performs scanning, the telecamera records images of the intensity of the interference fringes. By means of an analysis of the frequency domain it is possible to locate the height for each pixel in a highly precise and specific manner. The measurements obtained are both three-dimensional and two-dimensional: the vertical measurement (perpendicular to the surface being examined) is obtained by means of interferometry, while the lateral measurements (in the plane of the sample) are obtained by means of calibration of the enlargement generated by the lens. The 3D data which characterize the surface and can be obtained using the technique described are as follows:
height parameters: *Sq, SSk, Sku, Sp, Sv, Sz, Sa,* as defined according to the standard ISO 25178;
planarity parameters: *FLTt, FLTp, FLTv, FLTq,* as defined according to the standard ISO 12781;

The 2D data which characterize the surface and can be obtained using the technique described are as follows:
height parameters: *Rp, Rv, Rz, Rc, Rt, Ra, Rq, Rsk, Rku*, as defined according to the standard ISO 4287;
spacing parameters: *RSm, Rdq,* as defined according to the standard ISO 4287;
peak parameters: *RPc,* as defined according to the standard ISO 4287.

The value indicated above by *Ra*, among the height parameters, is the arithmetic mean surface roughness. Substrates which are useful for photovoltaic applications have *Ra* values preferably of between 10 and 150 nanometres, more preferably 30 and 90 nanometres. These values are advantageously obtained by the present invention, as shown in the tests below.

The article coated with the consolidated polymer film may be coated with an additional metallic film, for example consisting of molybdenum, copper, aluminium, platinum, silver, gold, etc., and with an absorbent film, for example so-called CI(G)S, i.e. films based on copper, indium, (gallium), diselenides, for the manufacture of thin-film photovoltaic devices. The application of these additional films may be performed using technologies which are known per se, for example sputtering.

As a result of the polymer coating applied in accordance with the present invention, the cementitious article does not require special production technologies and surface-finishing post-treatment in order to apply subsequently thin films for the manufacture of photovoltaic modules. The coating applied in accordance with the invention withstands effectively the vacuum and heating conditions which are typical of the thin-film deposition processes for photovoltaic applications, without losing the characteristics of adhesion to the cementitious substrate and without alteration of the surface properties thereof. The low roughness of the substrate coated in accordance with the invention is transferred to the superimposed thin (metallic, absorbent) films, resulting in a smooth and uniform final surface, of high value from an aesthetic point of view, stable over time in terms of adhesion, and resistant to the accumulation of dust and surface pollutants, with a performance which is reproducible over time.

The present invention comprises cementitious articles as defined in claim 9 coated with a polymer film and optionally with further superimposed films, having a high surface finish, obtained by means of the process according to the invention. The articles have preferably a small thickness, in particular of between 0.1 and 5 cm. The invention is also applicable to the use of said articles for the preparation of electrical devices, in particular photovoltaic devices. The invention also includes the use of said articles for the manufacture of photocatalytically active cementitious building elements, for example slabs, sunshade elements, ventilated-façade elements, etc.

The invention is now described in a non-limiting manner by the following examples.

### EXPERIMENTALS

### EXAMPLE 1

A prefabricated cementitious substrate with a thickness of 0.4 cm, previously obtained by casting a suitable mortar in moulds, was exposed to a pressure of 27 kPa (200 mmHg), at 120°C, for a time period of one hour.

The polyimide covering film was obtained by polycondensation from a solution of polyamidic acid in N-methylpyrrolidone, obtained from biphenyltetracarboxylic dianhydride copolymerized with phenylenediamine.

The solution of the precursor, at a concentration of 5% by weight, was applied by spin coating, onto the cementitious article in an amount proportional to the dimensions of the article itself, obtaining a layer of polymer solution with thickness of about 400 micrometres. After application, the material was placed in an oven at a temperature of 120°C, in vacuum conditions of 67 kPa (500 mmHg), for a duration of one hour. The sample was then subjected to a further heat treatment at 300°C, at atmospheric pressure, for two hours.

After consolidation and drying, the analysis on an optical profilometer revealed a homogeneous and continuous resin layer. The thickness of the applied resin film was equal to 20 micrometres and its arithmetic mean surface roughness equal to 40 nanometres. The product, obtained according to the invention, has therefore ideal characteristics for photovoltaic applications.

### EXAMPLE 1.A

The coated cementitious substrate obtained in Example 1 was introduced into a vacuum chamber of a sputtering device for deposition of a homogeneous film of metallic molybdenum, in order to produce a solar cell with a thin CIGS-based film. The thickness of the film was equal to 500 nanometres. Owing to the absence of surface defects, a continuous and homogeneous coating of the sample with the metallic molybdenum film was possible, as shown in Figure 1A.

### EXAMPLE 2

A prefabricated cementitious substrate with thickness of 0.4 cm, previously obtained by casting a suitable mortar in moulds, was exposed to a pressure of 27 kPa (200 mmHg), at 120°C, for a time period of one hour.

The polyimide covering film was obtained by polycondensation from a solution of polyamidic acid in N-methylpyrrolidone, obtained from pyromellitic anhydride copolymerized with oxydianiline.

The solution of the precursor, at a concentration of 5% by weight, was applied by spin coating, onto the cementitious article in an amount proportional to the dimensions of the article itself, obtaining a layer of polymer solution with thickness of about 400 micrometres. The material was placed in an oven at a temperature of 120°C, in vacuum conditions of 67 kPa (500 mmHg), for a duration of one hour. Then the sample was subjected to a further heat treatment at 300°C, at atmospheric pressure, for two hours.

After consolidation and drying, the analysis on a optical profilometer revealed a homogeneous and continuous resin layer. The thickness of the applied resin film was equal to 25 micrometres and its arithmetic mean surface roughness equal to 80 nanometres. The product, obtained according to the invention, has therefore ideal characteristics for photovoltaic applications.

### EXAMPLE 3 (REFERENCE)

A solution of polyamidic acid, at a concentration of 5% by weight, obtained from biphenyltetracarboxylic dianhydride copolymerized with phenylenediamine, was directly applied by spin coating, in an amount proportional to the dimensions of the article itself, onto a cementitious substrate similar to the preceding ones, but not subjected to the pre-treatment according to the invention, obtaining a polymer solution layer with a thickness of about 400 micrometres. The material, after application, was placed in an oven at 120°C, in vacuum conditions of 67 kPa (500 mmHg), for a duration of one hour. The sample was then subjected to a further heat treatment at 300°C, at atmospheric pressure, for two hours, in order to complete the in situ polymerization reaction.

The article thus obtained, without the pre-treatment according to the invention, was discontinuous and not homogeneous; the arithmetic mean surface roughness was equal to 530 micrometres, being therefore totally unsuitable for the manufacture of photovoltaic devices.

### EXAMPLE 3.A (REFERENCE)

The coated cementitious substrate obtained in Example 3 was introduced into a vacuum chamber of a sputtering device for deposition of a homogeneous film of metallic molybdenum, in order to produce a solar cell with a thin CIGS-based film. Owing to the presence of surface defects due to the lack of pre-treatment of the sample, a continuous and homogeneous coating of the sample with the metallic molybdenum film could not be obtained, as shown in Figure 1B.

## Claims

1. Process for the preparation of cementitious articles, with a high surface finish, suitable for the production of electrical devices, comprising:
a) treating a cementitious article at pressure conditions of between 1.3 and 100 kPa (10 and 750 mmHg), at a temperature of between 80 and 160°C, for a time period of between 40 and 120 minutes and subsequently
b) coating the surface of the article requiring finish with a film of a polymer selected from polyimide, polyarylketones or epoxy resins.

2. Process according to claim 1, wherein step a) is carried out at a pressure of between 6.7 and 80 kPa (50 and 600 mmHg), at a temperature of between 100 and 150°C, for a time period of between 45 and 90 minutes.

3. Process according to claim 1, wherein step a) is carried out at a pressure of between 13 and 67 kPa (100 and 500 mmHg), at a temperature of between 110 and 130°C, for a time period of between 50 and 70 minutes.

4. Process according to any one of claims 1-3, wherein the coating in step b) is applied by spin coating.

5. Process according to any one of claims 1-4, wherein the polymer in step b) is formed in situ on the surface of the cementitious article.

6. Process according to any one of claims 1-5, wherein the article obtained in step b) is coated with one or more additional films, useful for electrical, in particular photovoltaic applications.

7. Process according to any one of claims 1-6, wherein the polymer film obtained in b) has, after consolidation and drying, an arithmetic mean surface roughness *Ra* of between 30 and 90 nanometres.

8. Process according to any one of claims 1-7, wherein the polymer film obtained in b) has, after consolidation and drying, a thickness of between 5 and 150 micrometres.

9. Cementitious article with a high surface finish, suitable for the production of electrical devices, obtained by the process of claims 1-8, wherein the polymer film has, after consolidation and drying, an arithmetic mean surface roughness *Ra* of between 30 and 90 nanometres.

10. Article according to claims 9, wherein the polymer film has, after consolidation and drying, a thickness of between 5 and 150 micrometres.

11. Article according to any one of claims 9-10, with a thickness of between 0.1 and 5 cm.

12. Article according to any one of claims 9-11, coated with one or more additional films, useful for electrical, in particular photovoltaic applications.

13. Article according to any one of claims 9-12, in the form of a slab, sunshade element, ventilated-façade element, or any other element useful for application in Building Integrated Photovoltaics (BIPV).

14. Electrical device comprising one or more articles according to claims 9-13.

15. Device according to claim 14, said device being a photovoltaic device.

16. Use of one or more articles according to claims 9-13 in the preparation of electrical, in particular photovoltaic devices.

17. Use according to claim 16, wherein said devices are used in the field of Building Integrated Photovoltaics (BIPV).

## Patentansprüche

1. Verfahren zur Bereitstellung von Zementgegenständen mit hoher Oberflächengüte geeignet für die Herstellung von elektrischen Vorrichtungen, umfassend:
a) Behandeln eines Zementgegenstands bei Druckbedingungen zwischen 1.3 und 100 kPa (10 und 750 mmHg), bei einer Temperatur zwischen 80 und 160°C für eine Zeitdauer zwischen 40 und 120 Minuten und anschließend
b) Beschichten der Oberfläche des Gegenstands, welches ein Abschließen mit einer Schicht aus einem Polymer ausgewählt aus Polyimid, Polyarylketonen oder Epoxidharzen erfordert.

2. Verfahren nach Anspruch 1, wobei Schritt a) bei einem Druck zwischen 6,7 und 80 kPa (50 und 600 mmHg) bei einer Temperatur zwischen 100 und 150°C für eine Zeitdauer zwischen 45 und 90 Minuten durchgeführt wird.

3. Verfahren nach Anspruch 1, wobei Schritt a) bei einem Druck zwischen 13 und 67 kPa (100 und 500 mmHg), bei einer Temperatur zwischen 110 und 130°C für eine Zeitdauer zwischen 50 und 70 Minuten durchgeführt wird.

4. Verfahren nach einem der Ansprüche 1-3, wobei die Beschichtung in Schritt b) durch Rotationsbeschichtung aufgetragen wird.

5. Verfahren nach einem der Ansprüche 1-4, wobei das Polymer in Schritt b) in situ auf der Oberfläche des Zementgegenstandes gebildet wird.

6. Verfahren nach einem der Ansprüche 1-5, wobei der in Schritt b) erhaltene Gegenstand mit einer oder mehreren zusätzlichen Schichten beschichtet wird, welche für elektrische, insbesondere für Photovoltaik-Anwendungen, verwendbar ist/ sind.

7. Verfahren nach einem der Ansprüche 1-6, wobei die in b) erhaltene Polymerschicht nach Verfestigung und Trocknung eine arithmetisch gemittelte Oberflächenrauigkeit *Ra* zwischen 30 und 90 Nanometern aufweist.

8. Verfahren nach einem der Ansprüche 1-7, wobei die in b) erhaltene Polymerschicht nach Verfestigung und Trocknung eine Dicke zwischen 5 und 150 Mikrometern aufweist.

9. Zementgegenstand mit hoher Oberflächengüte geeignet für die Herstellung von elektrischen Vorrichtungen gewonnen gemäß einem Verfahren nach einem der Ansprüche 1 bis 8, wobei die Polymerschicht nach Verfestigung und Trocknung eine arithmetisch gemittelte Oberflächenrauigkeit *Ra* zwischen 30 und 90 Nanometern aufweist.

10. Gegenstand nach Anspruch 9, wobei die Polymerschicht nach Verfestigung und Trocknung eine Dicke zwischen 5 und 150 Mikrometern aufweist.

11. Gegenstand nach einem der Ansprüche 9-10 mit einer Dicke zwischen 0,1 und 5 cm.

12. Gegenstand nach einem der Ansprüche 9-11 beschichtet mit einer oder mehreren zusätzlichen Schichten, welche für elektrische, insbesondere für Photovoltaik-Anwendungen verwendbar ist/ sind.

13. Gegenstand nach einem der Ansprüche 9-12 in Form von einer Platte, eines Sonnenschutzelements, eines hinterlüfteten Fassadenelements, oder eines sonstiges Elementes, nützlich zur Verwendung bei gebäudeintegrierter Photovoltaik (BIPV).

14. Elektrische Vorrichtung, welche einen oder mehrere Gegenstände gemäß den Ansprüchen 9-13 umfasst.

15. Vorrichtung nach Anspruch 14, wobei die Vorrichtung eine Photovoltaikvorrichtung ist.

16. Verwendung eines oder mehrerer Gegenstände nach den Ansprüche 9-13 bei der Herstellung von elektrischen, insbesondere Photovoltaikvorrichtungen.

17. Verwendung nach Anspruch 16, wobei die Vorrichtungen auf dem Gebiet gebäudeintegrierter Photovoltaik (BIPV) verwendet werden.

## Revendications

1. Processus de préparation d'articles en ciment, qui présentent une finition de surface de grande qualité, adaptés pour la production de dispositifs électriques, qui comprend :
a) le traitement d'un article en ciment dans des conditions de pression de 1.3 à 100 kPa (10 à 750 mmHg), à une température de 80 à 160°C, pendant une durée de 40 à 120 minutes, puis
b) l'application, sur la surface de l'article qui nécessite une finition, d'un fiilm en polymère choisi parmi un polyimide, des polyarylkétones, ou des résines d'époxy.

2. Processus selon la revendication 1, dans lequel l'étape a) est réalisée à une pression de 6,7 à 80 kPa (50 à 600 mmHg), à une température de 100 à 150°c, pendant une durée de 45 à 90 minutes.

3. Processus selon la revendication 1, dans lequel l'étape a) est réalisée à une pression de 13 à 67 kPa (100 à 500 mmHg), à une température de 110 à 130°C, pendant une durée de 50 à 70 minutes.

4. Processus selon l'une quelconque des revendications 1 à 3, dans lequel le revêtement de l'étape b) est appliqué par centrifugation.

5. Processus selon l'une quelconque des revendications 1 à 4, dans lequel le polymère de l'étape b) est formé in situ sur la surface de l'article en ciment.

6. Processus selon l'une quelconque des revendications 1 à 5, dans lequel l'article obtenu à l'étape b) est recouvert d'un ou plusieurs film(s) supplémentaire(s), utile(s) pour les applications électriques, et plus particulièrement photovoltaïques.

7. Processus selon l'une quelconque des revendications 1 à 6, dans lequel le film de polymère obtenu à l'étape b) possède, après consolidation et séchage, une rugosité de surface arithmétique moyenne *Ra* de 30 à 90 nanomètres.

8. Processus selon l'une quelconque des revendications 1 à 7, dans lequel le film de polymère obtenu à l'étape b) possède, après consolidation et séchage, une épaisseur de 5 à 150 micromètres.

9. Article en ciment à finition de surface de grande qualité, adapté pour la production de dispositifs électriques, obtenu à l'aide du processus selon les revendications 1 à 8, dans lequel le film de polymère possède, après consolidation et séchage, une rugosité de surface arithmétique moyenne *Ra* de 30 à 90 nanomètres.

10. Article selon la revendication 9, dans lequel le film de polymère possède, après consolidation et séchage, une épaisseur de 5 à 150 micromètres.

11. Article selon l'une quelconque des revendications 9 et 10, qui présente une épaisseur de 0,1 à 5 cm.

12. Article selon l'une quelconque des revendications 9 à 11, recouvert d'un ou plusieurs film(s) supplémentaire(s), et utile pour les applications électriques, et plus particulièrement photovoltaïques.

13. Article selon l'une quelconque des revendications 9 à 12, sous la forme d'un bloc, d'un élément de parasol, d'un élément de façade ventilés, ou de quelconque autre élément utile pour les systèmes photovoltaïques intégrés à des bâtiments (BIPV).

14. Dispositif électrique qui comprend un ou plusieurs article(s) selon les revendications 9 à 13.

15. Dispositif selon la revendication 14, ledit dispositif étant un dispositif photovoltaïque.

16. Utilisation d'un ou plusieurs article(s) selon les revendications 9 à 13 pour la préparation de dispositifs électriques, et plus particulièrement photavaitaïques.

17. Utilisation selon la revendication 16, dans lequel lesdits dispositifs sont utilisés dans le domaine des systèmes photovoltaïques intégrés à des bâtiments (BIPV).
